# EUROPÄISCHE PATENTSCHRIFT

(11) **EP 2 694 697 B1**
(45) Veröffentlichungstag und Bekanntmachung des Hinweises auf die Patenterteilung: **01.08.2018**
(21) Anmeldenummer: 12725603.0
(22) Anmeldetag: 05.04.2012
(51) Int. Cl.: C23C 14/34, H01J 37/34

(54) **ROHRTARGET MIT SCHUTZVORRICHTUNG**
TUBULAR TARGET WITH PROTECTION MEANS
CIBLE TUBULAIRE AVEC DES MOYENS DE PROTECTION

(30) Priorität: 08.04.2011 AT 2032011 U
(43) Veröffentlichungstag der Anmeldung: 12.02.2014
(73) Patentinhaber: Plansee SE, 6600 Reutte (AT)
(72) Erfinder: LINKE, Christian, A-6610 Wängle (AT); SULIK, Manfred, A-6600 Reutte (AT); KATHREIN, Martin, A-6600 Reutte (AT)
(86) Internationale Anmeldenummer: PCT/AT2012/000094
(87) Internationale Veröffentlichungsnummer: WO 2012/135883

(56) Entgegenhaltungen:
- EP-A1- 0 500 031
- WO-A1-03/080891
- WO-A1-2008/150686
- WO-A2-01/77402

## Beschreibung

Die Erfindung betrifft ein trägerrohrloses Rohrtarget für die Kathodenzerstäubung aus Molybdän oder einer Molybdänlegierung mit einem Molybdängehalt von zumindest 50 At.%, das eine Sputteroberfläche und eine zumindest bereichsweise mit einem Kühlmedium in Kontakt stehende Innenoberfläche aufweist.

Rohrtargets aus Rein-Molybdän und Molybdänlegierungen, beispielsweise Mo-Na, werden für die Abscheidung von Mo-haltigen Schichten durch Kathodenzerstäubung, beispielsweise Magnetron-Sputtern, unter anderem bei der Herstellung von Dünnschichtsolarzellen auf der Basis von Cu(Inₓ,Ga₁₋ₓ)(Se_{y},S_{1-y})₂ (mit Ga: CIGS, ohne Ga:CIS) oder Dünnschichttransistoren für TFT-LCD eingesetzt. Die Mo-haltigen Schichten weisen dabei Dicken von wenigen nm bis hin zu einigen wenigen µm auf. Die zum Sputtern benötigten Ausgangsmaterialien (Kathoden) werden als Sputtering Targets bezeichnet und können je nach Ausführung der Beschichtungsanlagen in planarer oder rohrförmiger Geometrie eingesetzt werden. Rohrförmige Sputtering Targets, auch Rohrtargets genannt, werden während des Betriebs um ein feststehendes oder bewegtes Magnetsystem rotiert, das im Inneren des Targets angeordnet ist. Gegenüber planaren Sputtering Targets haben rohrförmige Sputtering Targets den Vorteil, dass ein gleichmäßiger Abtrag des Materials und damit eine höhere Materialausbeute erreicht werden. Besonders für teure Materialien mit aufwändiger Herstellung haben sich rohrförmige Sputtering Targets durchgesetzt. Bei Keramiken und spröden Werkstoffen wird das Rohrtarget mindestens zweiteilig ausgeführt, um die für die Halterung und Bewegung des Rohrtargets erforderlichen Kräfte nicht auf den spröden und damit bruchgefährdeten Sputterwerkstoff einwirken zu lassen. Dabei werden ein Rohr oder mehrere Rohrsegmente aus dem Sputterwerkstoff mit einem Trägerrohr, beispielsweise aus einem nichtmagnetischen Stahl oder Titan verbunden. Als Verbindungstechnik kommen beispielsweise Lötverfahren unter Verwendung von tiefschmelzenden Loten, beispielsweise Indium oder Indiumlegierungen, zum Einsatz.

Über 75% der beim Sputtern eingebrachten Energie wird als Wärme in das Sputtering Target eingebracht. Die durch den Beschuss mit energiereichen Ionen auf der Oberfläche des Sputtering Target erzeugte Wärmeenergie muss in ausreichend effektiver Weise abgeführt werden, um eine Überhitzung des Sputtering Target- und/oder des Lotmaterials zu verhindern. Die Kühlung der Sputtering Targets hat daher eine entscheidende Bedeutung. Bei Rohrtargets wird dabei die Innenoberfläche des Sputtering Targets ganzflächig oder bereichsweise durch ein durchströmendes Kühlmedium gekühlt. Das Kühlmedium hat dabei je nach Ausführung der Rohrtargets entweder direkten Kontakt mit dem Sputterwerkstoff oder dem Trägerrohr.

Rohrtargets aus Molybdän oder Molybdänlegierung werden verbreitet mit Trägerrohr eingesetzt. Nachteilig dabei ist nicht nur das aufwändige Verbinden von Sputterwerkstoff und Trägerrohr, sondern auch der durch das massive Trägerrohr und Lotmaterial behinderte Wärmeabfluss. So haben Stähle im Vergleich zu Molybdän deutlich schlechtere Wärmeleitungseigenschaften.

Wird nun ein Rohrtarget aus Molybdän oder einer Molybdän-Legierungen ohne Trägerrohr ausgeführt, ist ein direkter Kontakt des Kühlmediums mit dem Targetwerkstoff gegeben. Molybdän und Molybdänlegierungen korrodieren bei langdauernder Einwirkung üblicher Kühlmedien. Die Korrosionsrate beträgt dabei in Abhängigkeit von der Zusammensetzung und Art des Kühlmediums sowie der Einsatzbedingungen bis zu einigen 1/10 Millimeter pro Jahr. Durch das durch den Kontakt mit dem Kühlmedium bedingte Auflösen des Molybdäns und die dabei entstehenden Korrosionsprodukte (vornehmlich Molybdate oder Mischmolybdate, z.B. mit Cu) kommt es zu einer Änderung der Eigenschaften des Kühlmediums. So kann es zum Beispiel zu einer starken Erniedrigung des pH-Wertes des Kühlmediums und damit zu einem verstärkten Korrosionsangriff der weiteren im Kühlkreislauf eingesetzten Materialien (wie Kupfer, Messing, Edelstahl) kommen. Die Korrosion des Molybdäns und anderer Werkstoffe im Kühlkreislauf kann durch Zusatz von Inhibitoren auf organischer oder anorganischer Basis zum Kühlmittel gemindert, aber nicht gänzlich vermieden werden. Korrosionsinhibitoren für Molybdän werden beispielsweise in der US 4,719,035 (A) beschrieben. Eine regelmäßige Kontrolle des Zustands des Kühlmediums und eine eventuell notwendige Nachdosierung der Zusatzstoffe sind außerdem nur mit erhöhtem Anlagen-Aufwand möglich.

Eine beispielhafte Übersicht über die Eigenschaften von eingesetzten Kühlmedien ist in Tabelle 1 zusammengestellt.

**Tabelle 1**

| | |
|---|---|
| Kühlmedium | Destilliertes Wasser, enthärtetes Wasser, Leitungswasser |
| Einlauftemperatur | ca. 20°C |
| Auslauftemperatur | ca. 25-40°C |
| pH-Wert | 7,5 - 9,5 |
| Elektr. Leitwert | 100-2000 µS/cm |
| Inhibitoren | Organische Inhibitoren wie beispielsweise Thiazole, Triazole; anorganisch Inhibitoren wie beispielsweise Molybdate |
| Biozide | organische oder anorganische Breitbandbiozide |

Des Weiteren ist zu berücksichtigen, dass der Rohstoffpreis von Molybdän sehr hoch ist. Verbrauchte Sputtering Targets aus Molybdän werden üblicherweise nicht recycelt, sondern in kompakter Form als Legierungsmetall für die Herstellung von Stählen und Superlegierungen eingesetzt. Sortenreine (ohne Beimengungen von anderen Metallen) Schrotte erzielen dabei deutlich höhere Preise, als Mo-Schrotte, die für übliche Stahllegierungen artfremde Elemente enthalten. Molybdän-Rohrtargets mit Trägerrohr müssen daher zuerst entlötet werden und die Lotwerkstoffe, die üblicherweise für Stahllegierungen artfremd sind, aufwändig entfernt werden.

Die WO 01/77402 A2 betrifft eine Kathodenanordnung zum Magnetron-Sputtern, bei der mehrere Magneten in einer rohrförmigen Kathode verschiebbar angeordnet sind. Falls die eingesetzten Permanentmagneten empfindlich gegenüber dem eingesetzten Kühlmittel sind, wird vorgeschlagen, dass diese beschichtet oder anderweitig geschützt werden. Die WO 2008/150686 A1 betrifft das Befestigen eines zylindrischen Sputter-Targets auf einem Trägerrohr, indem ein Verbindungsmaterial, wie z.B. ein Indium-Lot, mittels Vakuum durch den dazwischen ausgebildeten Spalt gezogen wird. Der WO 03/080891 A1 liegt die Aufgabe zugrunde, einen einfachen Austausch von Rohrkathoden zu ermöglichen. Zur Lösung dieser Aufgabe wird eine drehbare Rohrkathode mit einer zylindrischen flexiblen Folie, die zwischen einem Targetträger bzw. einem Target und der zentralen Längsachse der Rohrkathode angeordnet ist, vorgeschlagen.

Aufgabe der gegenständlichen Erfindung ist es daher, ein Rohrtarget aus Molybdän oder einer Molybdänlegierung bereitzustellen, das die im Stand der Technik erwähnten Nachteile nicht aufweist. Im Besonderen ist dabei hervorzuheben, dass die Wärmeabfuhr in ausreichendem Ausmaß gewährleistet sein muss, dass über die gesamte Einsatzdauer des Rohrtargets Korrosion weitestgehend vermieden wird und dass verbrauchte Sputtering Targets in einfacher Art und Weise als Legierungsmaterial für die Stahlindustrie eingesetzt werden können.

Die Aufgabenstellung wird durch den kennzeichnenden Teil der unabhängigen Ansprüche 1 und 10 gelöst. Bevorzugte Ausführungsformen sind in den abhängigen Ansprüchen 2 bis 9 beansprucht. Mit der erfindungsgemäßen Ausführung wird zuverlässig Korrosion vermieden und die Wärmeabfuhr nicht unzulässig verschlechtert. Zudem lassen sich die verbrauchten Rohrtargets ohne aufwändiges Trennen oder Reinigen als Legierungsschrott für die Stahlherstellung einsetzten, da die Mengenanteile der Schutzvorrichtung bezogen auf den Molybdänanteil gering sind.

Das Rohrtarget besteht aus Rein-Molybdän oder einer Molybdänlegierung. Unter Molybdänlegierungen werden dabei alle Mo-haltigen Werkstoffe mit einem Mo-Gehalt von größer 50 At.% verstanden. Wird in weiterer Folge Molybdän erwähnt, umfasst dies immer Rein-Molybdän und Mo-haltige Werkstoffe mit einem Mo-Gehalt von größer 50 At.%. Das Rohrtarget ist trägerrohrlos ausgeführt. Trägerrohrlos bedeutet dabei, dass kein Trägerrohr zum Einsatz kommt. Das Molybdän-Rohrtarget wird daher direkt mit dem Haltesystem der Sputteranlage bzw. dem Endblock verbunden. Als Sputteroberfläche ist die Außenoberfläche des Rohrtargets bezeichnet. Die Innenoberfläche entspricht der inneren Wandung des Rohrtargets. Die gesamte mit dem Kühlmedium in Kontakt stehende Innenoberfläche ist nun durch zumindest eine Schutzvorrichtung vom Kühlmedium getrennt, wobei die Schutzvorrichtung zumindest ein Polymer umfasst und eine ein- oder mehrlagige Schicht ist. In vorteilhafter Weise besteht ein flächiger Kontakt zwischen dem Targetwerkstoff und der Schutzvorrichtung. Es ist vorteilhaft, wenn die Schutzvorrichtung eine Dicke (in radialer Richtung gemessen) von 0,0005 mm bis 1 mm aufweist. Besonders vorteilhaft ist es, wenn die Schutzvorrichtung eine Dicke (in radialer Richtung gemessen) von 0,0005 mm bis 0,1 mm aufweist. Beträgt die Wärmeleitfähigkeit der Schutzvorrichtung kleiner 1 W/m.K, ist eine Dicke der Schutzschicht von 0,0005 mm bis 0,5 mm zu bevorzugen. Um die Schichthaftung zu verbessern, ist es vorteilhaft, vor Aufbringen der Schutzvorrichtung die Innenoberfläche des Rohres vorzubehandeln, z.B. zu entfetten oder aufzurauen.

Zudem haben sich Materialien bewährt, die für die Stahlherstellung unkritisch sind, wie beispielsweise Polymere, deren Bestandteile (Kohlenstoff) zum einen bezogen auf den Gesamtgehalt des Stahls an Kohlenstoff, unkritische Beimengungen darstellen, zum anderen in Gasform bei der Stahlherstellung entweichen (Stickstoff, Wasserstoff, Chlor, Fluor,...).

In Hinblick auf Herstellkosten und Recyclefähigkeit ist es vorteilhaft, wenn die Schutzvorrichtung zumindest ein Polymer umfasst. Besonders vorteilhaft ist es wenn das Polymer eine Wärmeleitfähigkeit von größer 0,5 W/m.K, insbesondere größer 1 W/m.K aufweist. Auch elektrische Leitfähigkeit wirkt sich vorteilhaft auf die Einsatzeigenschaften des Rohrtargets aus. Thermische und/oder elektrische Leitfähigkeit werden beispielsweise erzielt, wenn das Polymer mit einem oder mehreren leitfähigen Füllstoffen versehen ist. Als geeignete Füllstoffe sind Werkstoffe der Gruppe Keramik, Grafit und Metall zu nennen. Besonders geeignete Füllstoffe sind Cu, Al, Si, Zn, Mo, W, Oxide, wie beispielsweise Al₂O₃, Nitride, wie beispielsweise AlN, TiN, BN, MoN oder SiN, Karbide wie beispielsweise SiC, TiC oder WC sowie Grafit.

Weiters ist es vorteilhaft, wenn die Schutzvorrichtung aus zumindest einem Polymer besteht.

Besonders geeignete Polymere, sowohl im ungefüllten als auch gefüllten Zustand sind Polymere der Gruppe Epoxidharz, Polyethylen, Polypropylen, Polyurethan, Polyvinylchlorid, Polyester, Vinylester und Fluorelastomer.

Die Schutzvorrichtung kann in vorteilhafter Weise mittels Nasslackieren, Streichen oder Sprühen auf-, bzw. eingebracht werden.

Jedoch sind auch andere Beschichtungsverfahren geeignet, wie beispielsweise chemische Gasphasenabscheidung (CVD), thermisches Spritzen, Kaltgasspritzen, Sol-Gel-Beschichtung, Plattieren, Kathodenzerstäubung (PVD), Galvanisieren, chemische und elektrochemische Verfahren, Sintern, Diffusionsbeschichten, Aufreiben oder Hintergießen.

Im Folgenden ist die Erfindung beispielhaft beschrieben.

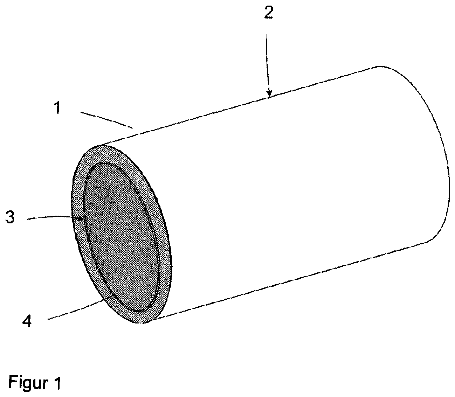

Figur 1 zeigt den Schrägriss des erfindungsgemäßen Rohrtargets -1- mit einer Sputteroberfläche -2-, einer Innenoberfläche -3- und einer Schutzvorrichtung -4-.

### Beispiel 1:

Ein Molybdän-Rohr -1- mit einem Innendurchmesser von 125 mm, einem Außendurchmesser von 165 mm, und einer Sputteroberfläche -2- wurde gemäß der in der EP 1 937 866 (A) beschriebenen Verfahrenstechnik hergestellt. Die zu beschichtende Innenoberfläche -3- des Molybdän-Rohrs wies eine Länge von 1500 mm auf. Die gedrehte Innenoberfläche wurde zunächst durch Sandstrahlen aufgeraut. Die anschließende Beschichtung erfolgte durch Aufpinseln eines Epoxidharzes mit einer Füllung von 70 Vol.% Al mit einer Partikelgröße von 50 µm. Die Schichtdicke der Schutzvorrichtung -4- betrug ca. 300 µm.

### Beispiel 2:

Zylindrische Molybdän-Proben mit einem Durchmesser von 10 mm und einer Länge von 50 mm wurden im unbeschichteten und beschichteten (Beispiele 2a bis 2g) Zustand in Auslagerungstests auf ihre Korrosionsbeständigkeit getestet. Die Proben wurden dabei in verschiedenen Kühlmedien über einen Zeitraum von 160 Stunden gelagert und der Masseverlust der Proben gemessen. Das Kühlmittelbad wurde während der Versuchsdauer mittels eines Magnetrührers bewegt. Die Ergebnisse der Messungen sind in Tabelle 2 dargestellt. Die mit R bezeichneten Proben (Referenzproben) entsprechen dem Stand der Technik (unbeschichtet). Beispiele 2a bis 2d sind erfindungsgemäße Beispiele.

### Beispiel 2a

Die gedrehte Oberfläche wurde durch Sandstrahlen aufgeraut. Die anschließende Beschichtung erfolgte durch Aufpinseln eines Epoxidharzes mit 70 Vol.% Al mit einer Partikelgröße von 50 µm. Die Schichtdicke betrug ca. 300 µm.

### Beispiel 2b:

Die gedrehte Oberfläche wurde durch Sandstrahlen aufgeraut. Die anschließende Beschichtung erfolgte durch Nasslackieren mit einem Alkydharzlack (ein Polyester), der an Luft ausgetrocknet wurde. Die Schichtdicke betrug ca. 100 µm.

### Beispiel 2c:

Die gedrehte Oberfläche wurde durch Sandstrahlen aufgeraut. Die anschließende Beschichtung erfolgte durch Aufpinseln eines Epoxidharzes mit einer Füllung von 70 Vol.% Al₂O₃. Die Schichtdicke betrug ca. 300 µm.

### Beispiel 2d:

Die gedrehte Oberfläche wurde durch Beizen gereinigt und entfettet. Die anschließende Beschichtung erfolgte mittels Pulversprühen einer Polyurethan-Verbindung. Die Schichtdicke betrug ca. 500 µm.

### Beispiel 2e (nicht erfindungsgemäß):

Die gedrehte Oberfläche wurde durch Beizen gereinigt und entfettet. Auf üblichem galvano-chemischem Wege (Kupfersulfatbasis) wurde eine Kupferschicht mit einer Dicke von 15 µm abgeschieden.

### Beispiel 2f (nicht erfindungsgemäß):

Die gedrehte Oberfläche wurde durch Sandstrahlen aufgeraut. Anschließend wurde ein SiO₂ basierender Slurry aufgebracht und bei 200°C / 60 min. wärmebehandelt.

### Beispiel 2g (nicht erfindungsgemäß):

Die gedrehte Oberfläche wurde durch Sandstrahlen aufgeraut. Anschließend wurde eine TiN Schicht mit einer Dicke von 2 µm mittels CVD aufgebracht.

**Tabelle 2**

| **Probe** | **Kühlwasser** | **Inhibitor** | **Korrosionsrate [mm/a]** | **Änderung pH-Wert** | **Mo-Gehalt im Wasser [mg]** |
|---|---|---|---|---|---|
| R | Leitungswasser | nein | 0,9 | 4 | 2300 |
| R | Osmosewasser | Nein | 0,7 | 2 | 1500 |
| R | Leitungswasser | ja | 0,01 | 0-1 | 20 |
| R | Osmosewasser | ja | 0,2 | 3-4 | 400 |
| Bsp.2a | Leitungswasser | Nein | <0,0001 | <0,1 | <1 |
| Bsp.2a | Osmosewasser | Nein | <0,0001 | <0,1 | <1 |
| Bsp.2a | Leitungswasser | ja | <0,0001 | <0,1 | <1 |
| Bsp.2a | Osmosewasser | ja | <0,0001 | <0,1 | <1 |
| Bsp.2b | Leitungswasser | Nein | <0,0001 | <0,1 | <1 |
| Bsp.2c | Leitungswasser | Nein | <0,0001 | <0,1 | <1 |
| Bsp.2d | Leitungswasser | Nein | <0,0001 | <0,1 | <1 |
| Bsp.2e | Leitungswasser | Nein | <0,0001 | <0,1 | <1 |
| Bsp.2f | Leitungswasser | Nein | <0,0001 | <0,1 | <1 |
| Bsp.2g | Leitungswasser | Nein | <0,0001 | <0,1 | <1 |

## Patentansprüche

1. Trägerrohrloses Rohrtarget (1) für die Kathodenzerstäubung aus Molybdän oder einer Molybdänlegierung mit einem Molybdängehalt von zumindest 50 At.%, umfassend eine Sputteroberfläche (2) und eine zumindest bereichsweise mit einem Kühlmedium in Kontakt stehende Innenoberfläche (3),
**dadurch gekennzeichnet,**
**dass** die gesamte mit dem Kühlmedium in Kontakt stehende Innenoberfläche (3) durch zumindest eine Schutzvorrichtung (4) vom Kühlmedium getrennt ist, wobei die Schutzvorrichtung (4) zumindest ein Polymer umfasst und eine ein- oder mehrlagige Schicht ist.

2. Rohrtarget (1) nach Anspruch 1, **dadurch gekennzeichnet, dass** die Schutzvorrichtung (4) in flächigem Kontakt mit der Innenoberfläche (3) steht.

3. Rohrtarget (1) nach Anspruch 1 oder 2, **dadurch gekennzeichnet, dass** die Schutzvorrichtung (4) eine Dicke von 0,0005 mm bis 1 mm aufweist.

4. Rohrtarget (1) nach Anspruch 3, **dadurch gekennzeichnet, dass** die Schutzvorrichtung (4) eine Dicke von 0,0005 mm bis 0,1 mm aufweist.

5. Rohrtarget (1) nach einem der vorangehenden Ansprüche, **dadurch gekennzeichnet, dass** das Polymer thermisch und / oder elektrisch leitfähig ist.

6. Rohrtarget (1) nach einem der vorangehenden Ansprüche, **dadurch gekennzeichnet, dass** das Polymer mit einem Füllstoff versehen ist.

7. Rohrtarget (1) nach Anspruch 6, **dadurch gekennzeichnet, dass** der Füllstoff zumindest einen Werkstoff der Gruppe Keramik, Graphit und Metall umfasst.

8. Rohrtarget (1) nach einem der vorangehenden Ansprüche, **dadurch gekennzeichnet, dass** die Schutzvorrichtung (4) aus zumindest einem Polymer besteht.

9. Rohrtarget (1) nach einem der vorangehenden Ansprüche, **dadurch gekennzeichnet, dass** das Polymer ein Polymer der Gruppe Epoxidharz, Polyethylen, Polypropylen, Polyurethan, Polyvinylchlorid, Polyester, Vinylester und Fluorelastomer ist.

10. Verfahren zur Herstellung eines Rohrtargets (1) nach einem der vorangehenden Ansprüche, **dadurch gekennzeichnet, dass** die Schutzvorrichtung (4) mittels einer Verfahrenstechnik der Gruppe Nasslackieren und Sprühen eingebracht wird.

## Claims

1. Tubular target (1) for cathode atomization which has no backing tube and is made of molybdenum or a molybdenum alloy with a molybdenum content of at least 50 at.%, comprising a sputtering surface (2) and an inner surface (3) which is in contact at least in certain regions with a cooling medium,
**characterized**
**in that** all of the inner surface (3) which is in contact with the cooling medium is separated from the cooling medium by at least one protective device (4), wherein the protective device (4) comprises at least one polymer and is a single-ply or multi-ply layer.

2. Tubular target (1) according to Claim 1, **characterized in that** the protective device (4) is in areal contact with the inner surface (3).

3. Tubular target (1) according to Claim 1 or 2, **characterized in that** the protective device (4) has a thickness of 0.0005 mm to 1 mm.

4. Tubular target (1) according to Claim 3, **characterized in that** the protective device (4) has a thickness of 0.0005 mm to 0.1 mm.

5. Tubular target (1) according to any of the preceding claims, **characterized in that** the polymer is thermally and/or electrically conductive.

6. Tubular target (1) according to any of the preceding claims, **characterized in that** the polymer is provided with a filler.

7. Tubular target (1) according to Claim 6, **characterized in that** the filler comprises at least one material from the group consisting of ceramic, graphite and metal.

8. Tubular target (1) according to any of the preceding claims, **characterized in that** the protective device (4) consists of at least one polymer.

9. Tubular target (1) according to any of the preceding claims, **characterized in that** the polymer is a polymer from the group consisting of epoxy resin, polyethylene, polypropylene, polyurethane, polyvinyl chloride, polyester, vinyl ester and fluoroelastomer.

10. Method for producing a tubular target (1) according to any of the preceding claims, **characterized in that** the protective device (4) is introduced by means of a process from the group consisting of wet coating and spraying.

## Revendications

1. Cible tubulaire sans tube porteur (1) pour la pulvérisation cathodique en molybdène ou en un alliage de molybdène ayant une teneur en molybdène d'au moins 50 % atomiques, comprenant une surface de pulvérisation cathodique (2) et une surface intérieure (3) se trouvant au moins localement en contact avec un milieu de refroidissement, **caractérisée en ce que** toute la surface intérieure (3) se trouvant en contact avec le milieu de refroidissement est séparée du milieu de refroidissement par au moins un dispositif de protection (4), dans lequel le dispositif de protection (4) comprend au moins un polymère et est une couche en une ou plusieurs couches.

2. Cible tubulaire (1) selon la revendication 1, **caractérisée en ce que** le dispositif de protection (4) est en contact de surface avec la surface intérieure (3).

3. Cible tubulaire (1) selon la revendication 1 ou 2, **caractérisée en ce que** le dispositif de protection (4) présente une épaisseur de 0,0005 mm à 1 mm.

4. Cible tubulaire (1) selon la revendication 3, **caractérisée en ce que** le dispositif de protection (4) présente une épaisseur de 0,0005 mm à 0,1 mm.

5. Cible tubulaire (1) selon l'une quelconque des revendications précédentes, **caractérisée en ce que** le polymère est thermiquement et/ou électriquement conducteur.

6. Cible tubulaire (1) selon l'une quelconque des revendications précédentes, **caractérisée en ce que** le polymère est doté d'une matière de charge.

7. Cible tubulaire (1) selon la revendication 6, **caractérisée en ce que** la matière de charge comprend au moins un matériau du groupe céramique, graphite et métal.

8. Cible tubulaire (1) selon l'une quelconque des revendications précédentes, **caractérisée en ce que** le dispositif de protection (4) se compose d'au moins un polymère.

9. Cible tubulaire (1) selon l'une quelconque des revendications précédentes, **caractérisée en ce que** le polymère est un polymère du groupe résine époxy, polyéthylène, polypropylène, polyuréthane, polychlorure de vinyle, polyester, ester vinylique et fluoroélastomère.

10. Procédé de fabrication d'une cible tubulaire (1) selon l'une quelconque des revendications précédentes, **caractérisé en ce que** l'on introduit le dispositif de protection (4) au moyen d'un procédé technique du groupe laquage humide et pulvérisation.
